# EUROPÄISCHE PATENTSCHRIFT

(11) **EP 1 322 033 B1**
(45) Veröffentlichungstag und Bekanntmachung des Hinweises auf die Patenterteilung: **11.05.2005**
(21) Anmeldenummer: 02027497.3
(22) Anmeldetag: 10.12.2002
(51) Int. Cl.: H03B 5/36

(54) **Quarzoszillatorschaltung**
Quartz oscillator circuit
Circuit d'oscillateur à quartz

(30) Priorität: 20.12.2001 DE 10162912
(43) Veröffentlichungstag der Anmeldung: 25.06.2003
(73) Patentinhaber: Infineon Technologies AG, 81669 München (DE)
(72) Erfinder: Körner, Heiko, 8152 Stallhofen (AT)
(74) Vertreter: Epping Hermann & Fischer

(56) Entgegenhaltungen:
- GB-A- 1 424 559
- US-A- 5 202 647
- US-A- 5 745 012
- PATENT ABSTRACTS OF JAPAN vol. 2000, no. 11, 3. Januar 2001 (2001-01-03) -& JP 2000 223948 A (HITACHI LTD), 11. August 2000 (2000-08-11)
- PATENT ABSTRACTS OF JAPAN vol. 009, no. 047 (E-299), 27. Februar 1985 (1985-02-27) & JP 59 188203 A (HITACHI SEISAKUSHO KK), 25. Oktober 1984 (1984-10-25)
- BURCH K R: "METHOD TO REDUCE RFI IN A CMOS PIERCE CRYSTAL OSCILLATOR" MOTOROLA TECHNICAL DEVELOPMENTS, MOTOROLA INC. SCHAUMBURG, ILLINOIS, US, Bd. 10, 1. März 1990 (1990-03-01), Seite 82 XP000114660 ISSN: 0887-5286
- PATENT ABSTRACTS OF JAPAN vol. 1997, no. 08, 29. August 1997 (1997-08-29) -& JP 09 102714 A (ASAHI KASEI MICRO SYST KK), 15. April 1997 (1997-04-15)

## Beschreibung

Die folgende Erfindung betrifft eine Quarzoszillatorschaltung.

Quarzoszillatoren sind schwingungsfähige elektrische Systeme, welche gegenüber den LC-Oszillatoren eine bessere Frequenzkonstanz aufweisen. Dabei werden Schwingquarze verwendet, die mit elektrischen Feldern zu mechanischen Schwingungen angeregt werden. Ein Schwingquarz mit angeschlossenen Elektroden verhält sich elektrisch wie ein Schwingkreis hoher Güte.

Ein sogenannter Pierce-Oszillator, der ein Vertreter der Grundwellen-Oszillatoren ist, weist zwei Kondensatoren auf, die einen Serienschwingkreis bilden, der durch einen Verstärker angeregt wird. Als Verstärker kommt dabei beispielsweise ein Complementary Metal Oxide Semiconductor(CMOS)-Inverter zum Einsatz. Ein derartiger Pierce-Oszillator ist beispielsweise in dem Dokument Tietze, Schenk: Halbleiter-Schaltungstechnik, 10. Auflage 1993, auf Seiten 466 - 469 angegeben. Bei dem Pierce-Oszillator ist einer der beiden Kondensatoren verstellbar ausgeführt. Durch Verstellen der Serienkapazität wird die Schwingfrequenz des Schwingkreises beeinflusst. Die Frequenzverstellung mit Kapazitäten kann aber beispielsweise auch durch Zu- oder Wegschalten von Teilkapazitäten in diskreten Schritten erfolgen.

Bei derartigen Quarzoszillatoren, bei denen die Frequenzeinstellung durch gegen Masse geschaltete Kapazitäten vorgenommen wird, kann es vorkommen, daß der Arbeitspunkt so weit verschoben wird, daß die Phasenreserve des schwingungsfähigen Systems nicht mehr ausreicht und das System instabil wird. Insbesondere bei Oszillatoren, welche eine Amplitudenregelung aufweisen, ist eine derartige Instabilität nachteilhaft.

Aufgabe der vorliegenden Erfindung ist es, eine Quarzoszillatorschaltung anzugeben, welche bezüglich ihres Stabilitätsverhaltens verbessert ist.

Erfindungsgemäß wird die Aufgabe gelöst durch eine Quarzoszillatorschaltung, aufweisend
- einen Schwingquarz mit einem ersten und einem zweiten Anschluß,
- einen Entdämpfungsverstärker mit einem Eingang und einem Ausgang, die mit je einem Anschluß des Schwingquarzes gekoppelt sind,
- ein Mittel zur Arbeitspunkteinstellung, welches den Schwingquarz mit dem Eingang des Entdämpfungsverstärkers koppelt,
- ein erstes kapazitives Bauteil, welches den ersten Anschluß des Schwingquarzes mit einem Bezugsknoten verbindet,
- ein zweites kapazitives Bauteil, welches den zweiten Anschluß des Schwingquarzes mit dem Bezugsknoten verbindet,
- wobei zumindest eines der beiden kapazitiven Bauteile verstellbar ausgebildet, und
- eine Kompensationskapazität, welche einerseits mit dem Eingang des Entdämpfungsverstärkers und andererseits mit dem Bezugsknoten verbunden ist, mit einer Ansteuerung, die eine gegengleiche Verstellung zu dem kapazitiven Bauteil bewirkt.

Durch Zu- oder Wegschalten des ersten und zweiten kapazitiven Bauteils wird bei dem beschriebenen Prinzip gemäß einer Weiterbildung des Pierce-Oszillators die Schwingfrequenz des Oszillators verstellt. Das Einführen einer Kompensationskapazität ermöglicht die Beibehaltung eines stabilen Verhaltens der Oszillatorschaltung. Die Kompensationskapazität ist vom eigentlichen Schwingkreis durch das Mittel zur Arbeitspunkteinstellung entkoppelt, so daß sich das Hinzu- oder Wegschalten der Kompensationskapazität zwar wie gewünscht auf den Arbeitspunkt des Entdämpfungsverstärkers auswirkt, nicht jedoch auf die eigentliche Schwingfrequenz der Quarzoszillatorschaltung.

Die Kompensationskapazität wird gegenüber erstem und zweitem kapazitiven Bauteil gegengleich verstellt. Das bedeutet, daß bei Hinzuschalten des ersten und zweiten kapazitiven Bauteils die Kompensationskapazität weggeschaltet wird und umgekehrt. Hierdurch bleibt bei geeigneter Dimensionierung der Arbeitspunkt des Entdämpfungsverstärkers gerade erhalten. Die Kompensationskapazität wirkt sich demnach lediglich auf den dynamischen Arbeitspunkt des Entdämpfungsverstärkers aus.

Gemäß einer vorteilhaften Weiterbildung der Erfindung sind mehrere erste und mehrere zweite kapazitive Bauelemente vorgesehen. Dabei sind die mehreren ersten kapazitiven Bauelemente miteinander parallel verschaltet. Die mehreren zweiten kapazitiven Bauelemente sind ebenfalls miteinander parallel verschaltet.

Da die ersten und zweiten kapazitiven Bauelemente jeweils zu- und abschaltbar ausgeführt sind, können die Parallelschaltungen bevorzugt je eine Serienschaltung eines Schalters und einer der mehreren ersten oder zweiten kapazitiven Bauelemente umfassen.

Die mehreren ersten und mehreren zweiten kapazitiven Bauelemente sind bevorzugt paarweise vorgesehen. Dabei wird je ein erstes und je ein zweites kapazitives Bauelement zugleich zu- oder abgeschaltet.

Mit der Vielzahl von kapazitiven Bauelementen kann die Frequenz, auf der der Schwingquarz schwingt, in beliebig vielen Schritten verstellt werden.

Dabei kann bevorzugt jedem Paar aus einem ersten und einem zweiten kapazitiven Bauelement je eine Kompensationskapazität zugeordnet sein. Die Kompensationskapazität hat dabei zu dem zugeordneten ersten und zweiten kapazitiven Bauelement je ein festes Kapazitätsverhältnis. Gemäß dem vorliegenden Prinzip wird dabei jeweils ein Paar von ersten und zweiten kapazitiven Bauelementen zugleich mit der zugeordneten Kompensationskapazität geschaltet, jedoch gegengleich. Das bedeutet, daß bei Zuschalten eines Paars aus einem ersten und einem zweiten kapazitiven Bauelements die diesem Paar zugeordnete Kompensationskapazität, die zu beiden ein festes Kapazitätsverhältnis hat, abgeschaltet wird. Bei geeigneter Dimensionierung ist mit dem vorgeschlagenen Prinzip zum einen ein einfaches Layout einer Quarzoszillatorschaltung gewährleistet und zum anderen eine exakte Kompensation bezüglich des dynamischen Arbeitspunktes des Entdämpfungsverstärkers erreicht.

Zum Erzielen der gegengleichen Schaltbarkeit zugeordneter Kapazitäten ist bevorzugt eine Ansteuerschaltung vorgesehen, welche Steueranschlüssen der dem ersten und zweiten kapazitiven Bauteils jeweils zugeordneten Schalter ein Steuersignal nicht-invertiert zuführt. Dem Schalter, der an diejenige Kompensationskapazität angeschlossen ist, die dem Paar von erstem und zweitem kapazitiven Bauteil zugeordnet ist, wird dieses Steuersignal an seinem Steueranschluß invertiert zugeführt. Hierdurch ist das dem vorliegenden Prinzip zugrundeliegende, gegengleiche Schalten der Kompensationskapazität bezüglich erstem und zweitem kapazitiven Bauteil erreicht.

Bevorzugt sind die Kapazitätswerte des ersten und zweiten kapazitiven Bauteils viel größer als der Kapazitätswert des ihnen zugeordneten, kompensierenden kapazitiven Bauteils. Die Kapazitätswerte von erstem und zweitem kapazitiven Bauteil, die gemeinsam ein Paar bilden, sind dabei bevorzugt gleich. Der Quotient aus dem Kapazitätswert des ersten kapazitiven Bauteils und dem Kapazitätswert der zugeordneten Kompensationskapazität ist bevorzugt größer als 5.

Hierdurch wird verbessert sichergestellt, daß das Hinzu- oder Wegschalten von Kompensationskapazitäten lediglich den dynamischen Arbeitspunkt des Entdämpfungsverstärkers beeinflußt, nicht jedoch die Schwingfrequenz des Quarzoszillators selbst.

Gemäß einer weiteren, vorteilhaften Ausführungsform der vorliegenden Erfindung ist eine Mindestkapazität vorgesehen, welche den Eingang des Entdämpfungsverstärkers fest mit dem Bezugsknoten verbindet.

Die Mindestkapazität bildet mit dem bevorzugt als Widerstand ausgebildeten Mittel zur Arbeitspunkteinstellung ein RC-Glied, welches Tiefpaßeigenschaften hat. Ein derartiges Tiefpaßfilter unterstützt mit Vorteil die Stabilität der Quarzoszillatorschaltung.

Die beschriebene Quarzoszillatorschaltung ist bevorzugt als integrierte Schaltung in Complementary Metal Oxide Semiconductor-(CMOS-)Schaltungstechnik aufgebaut.

Der Entdämpfungsverstärker ist bevorzugt als CMOS-Inverter ausgebildet.

Weitere Einzelheiten und vorteilhafte Ausgestaltungen der vorliegenden Quarzoszillatorschaltung sind Gegenstand der Unteransprüche.

Die Erfindung wird nachfolgend an mehreren Ausführungsbeispielen anhand der Zeichnungen näher erläutert.

Es zeigen:
- Figur 1: ein vereinfachtes Schaltbild einer ersten Ausführungsform einer Quarzoszillatorschaltung gemäß vorliegendem Prinzip,
- Figur 2: anhand eines S-Parameter-Schaubilds die Kompensation von Arbeitspunkt-Verschiebungen bei vorliegender Quarzoszillatorschaltung anhand des Realteils der Eingangsadmittanz aufgetragen über der Frequenz und
- Figur 3: eine Weiterbildung der Quarzoszillatorschaltung von Figur 1 mit in mehreren Schritten diskret verstellbarer Schwingfrequenz.

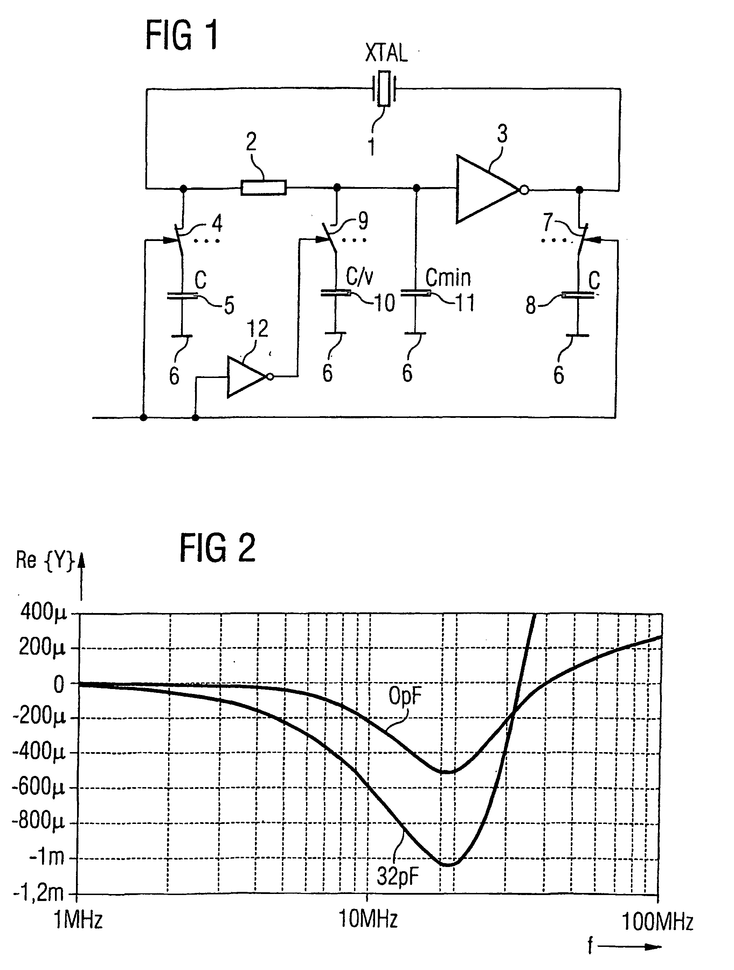

Figur 1 zeigt eine Quarzoszillatorschaltung mit einem Schwingquarz 1, welcher zwei Anschlüsse hat. Der Schwingquarz 1 ist mit einem ersten Anschluß über einen Widerstand 2 an einen Eingang eines Inverters 3 angeschlossen. Ein Ausgang des Inverters 3 ist mit dem weiteren Anschluß des Schwingquarzes 1 verbunden. Eine Serienschaltung aus einem Schalter 4 und einem Kondensator 5 ist mit einem Anschluß zwischen Schwingquarz 1 und Widerstand 2 und mit einem weiteren Anschluß mit einem Bezugsknoten 6 verbunden, der an Bezugspotential angeschlossen ist. Eine weitere Serienschaltung aus einem Schalter 7 und einer Kapazität 8, die den gleichen Kapazitätswert wie der Kondensator 5 aufweist, ist zwischen dem Ausgang des Inverters 3 und dem Bezugsknoten 6 angeschlossen. Am Eingang des Inverters 3, demnach zwischen Widerstand 2 und Inverter 3, ist eine Serienschaltung aus einem Schalter 9 und einer Kompensationskapazität 10 gegen den Bezugsknoten 6 geschaltet. Parallel zu dieser Serienschaltung aus Schalter 9 und Kompensationskapazität 10 ist eine Mindestkapazität 11 gegen Bezugsknoten 6 angeschlossen. Die Mindestkapazität 11 bildet mit dem Widerstand 2 ein RC-Glied, welches als Tiefpaß wirkt.

Die erstes kapazitives Bauteil 5 und zweites kapazitives Bauteil 8 wirksam zu- und abschaltenden Schalter 4, 7 sind aufgrund der Verbindung ihrer Steueranschlüsse miteinander mit gleichem Ansteuersignal jeweils zugleich geschaltet, während der der Kompensationskapazität 10 zugeordnete Schalter 9 invertiert schaltet, wofür am Steueranschluß des Schalters 9 ein Inverter 12 angeschlossen ist, dem das Ansteuersignal zugeführt wird. Der Eingang des Inverters 12 ist dabei mit den Steueranschlüssen der Schalter 4, 7 verbunden, die dem ersten und dem zweiten kapazitiven Bauteil 5, 8 zugeordnet sind. Demnach schließt Schalter 9, wenn Schalter 4 und 7 öffnen und umgekehrt.

Erstes und zweites kapazitives Bauteil 5, 8 sind jeweils gegen Bezugspotentialanschluß 6 oder Masseanschluß geschaltet und dienen zur Frequenzeinstellung des von der Quarzoszillatorschaltung gebildeten Schwingkreises. Hierdurch ist normalerweise eine stabilitätsgefährdende, unerwünschte Verschiebung des Arbeitspunktes der Schaltung, insbesondere des Entdämpfungsverstärkers 3, der im vorliegenden Beispiel als CMOS-Inverter ausgebildet ist, bewirkt. Gegengleich zu den Schwingkreis-frequenzbestimmenden Kapazitäten 5, 8 wird die verhältnismäßig kleinere Kompensationskapazität 10 geschaltet, welche bezüglich ihres Kapazitätswertes ein festes Verhältnis zu den schwingkreisbestimmenden Kapazitäten 5, 8 hat. Letztere Kapazitäten 5, 8 haben den gleichen Kapazitätswert. Dadurch, daß die Kompensationskapazität 10 einen kleineren Kapazitätswert besitzt und zudem über den Widerstand 2, der zur Arbeitspunkteinstellung des Inverters 3 dient, entkoppelt ist, hat sie lediglich einen sehr geringen Einfluß auf die Schwingfrequenz, jedoch einen bedeutenden Einfluß auf den dynamischen Arbeitspunkt. Im vorliegenden Beispiel weisen die kapazitiven Bauteile 5, 8, welche die Schwingfrequenz bestimmen, jeweils einen Kapazitätswert von 32 Picofarad auf, während der Kapazitätswert des Kompensationskondensators 10 zwischen 3 und 4 pF liegt und demnach circa um den Faktor 10 kleiner ist als die Kapazitätswerte von erstem und zweitem kapazitiven Bauteil 5, 8.

Mit der Kompensationskapazität 10, welche gegengleich zu den kapazitiven Bauteilen 5, 8 angesteuert wird, bleibt folglich die Stabilität des Oszillators sowie dessen Aussteuerbereich, erhalten. Dies ist beispielsweise bei Vorsehen einer zusätzlichen Amplituden- oder Frequenzmodulation der Quarzoszillatorschaltung von Vorteil.

Figur 2 zeigt anhand eines Schaubildes in halblogarithmischer Darstellung den Realteil der Eingangsadmittanz des Quarzoszillators aufgetragen über der Frequenz desselben. Man erkennt, daß unabhängig davon, ob die Kapazitäten 5, 8 mit dem Kapazitätswert von 32 Picofarat zugeschaltet sind oder nicht, jeweils der gleiche Arbeitspunkt bei der Arbeitsfrequenz des Quarzes erhalten bleibt. Dies wird durch gegengleiches Zu- und Wegschalten der Kompensationskapazität 10, wie anhand des Schaltbildes von Figur 1 erläutert, erzielt.

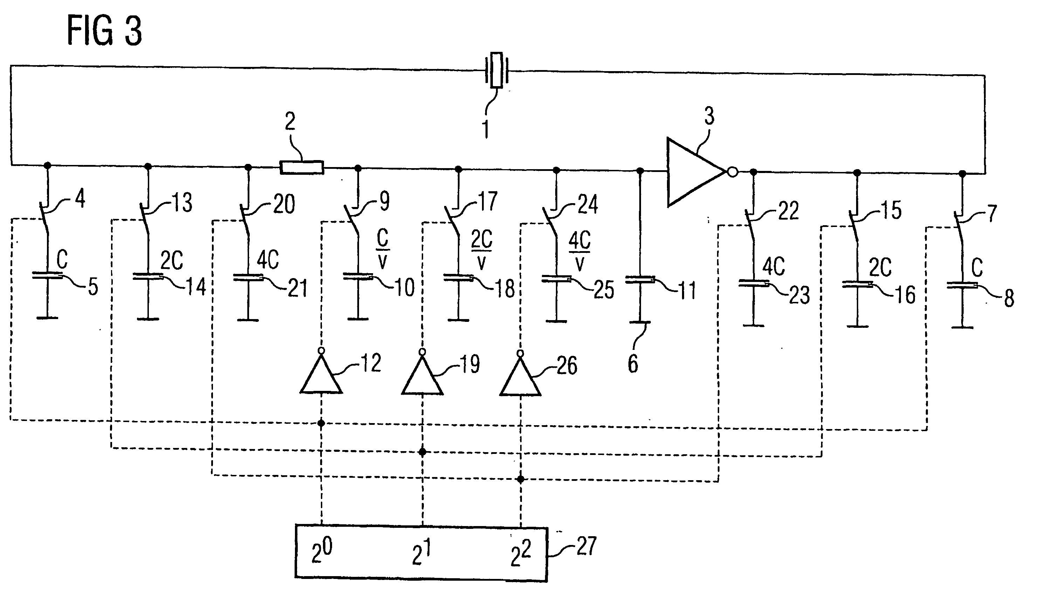

Figur 3 zeigt eine Weiterbildung der Quarzoszillatorschaltung von Figur 1, bei der die Schwingfrequenz des Quarzoszillators nicht nur zwischen zwei diskreten Frequenzen umschaltbar ist, sondern eine Vielzahl von diskreten Schwing-Frequenzen dadurch einstellbar ist, daß mehrere Paare von kapazitiven Bauteilen 5, 8; 14, 16; 21, 23 vorgesehen sind, denen jeweils eine Kompensationskapazität 10, 18, 25 zugeordnet ist.

Die Quarzoszillatorschaltung gemäß Figur 3 entspricht in Aufbau und Funktionsweise weitgehend der Quarzoszillatorschaltung von Figur 1 und umfaßt alle Bauteile, die dort gezeigt sind, in gleicher vorteilhafter Verschaltung miteinander. Insoweit wird auf eine Wiederholung der Figurenbeschreibung an dieser Stelle verzichtet.

Zusätzlich zu den bei der Quarzoszillatorschaltung gemäß Figur 1 gezeigten Bauteilen umfaßt die Quarzoszillatorschaltung gemäß Figur 3 weitere Serienschaltungen aus je einem Schalter 13, 20 und einer ersten Kapazität 14, 21, die parallel zur Serienschaltung aus Schalter 4 und erster Kapazität 5 geschaltet sind. Symmetrisch hierzu sind auch zur Serienschaltung aus Schalter 7 und zweiter Kapazität 8 zwei weitere Serienschaltungen aus je einem Schalter 15, 22 und je einer Kapazität 16, 23 geschaltet. Zusätzlich sind auch parallel zu der Kompensationskapazität 10, welche mit dem ihr zugeordneten Schalter 9 eine Serienschaltung bildet, weitere Serienschaltungen aus je einem Schalter 17, 24 und einer weiteren Kompensationskapazität 18, 25 vorgesehen, welche parallel zu der Serienschaltung aus Schalter 9 und Kompensationskapazität 10 geschaltet sind. In Analogie zur Ansteuerung der Kompensationskapazität 10 mittels Schalter 9 und Inverter 12 sind auch zur Ansteuerung der Schalter 17, 24, die an die weiteren Kompensationskapazitäten 18, 25 angeschlossen sind, jeweils Inverter 19, 26 vorgesehen.

Ebenso wie die Kondensatoren 5, 8, die ein gemeinsam und zeitgleich angesteuertes Paar bilden, bilden auch die Kondensatoren 14, 16 und 21, 23 jeweils ein gemeinsam angesteuertes Paar von Kondensatoren.

Die ersten und zweiten kapazitiven Bauteile 5, 8; 14, 16; 21, 23 sind zueinander paarweise binär abgestuft. Entsprechend sind auch die zugeordneten Kompensationskapazitäten 10, 18, 25 zueinander binär abgestuft, derart, daß das Kapazitätsverhältnis V aus erster bzw. zweiter Kapazität 5, 8; 14, 16; 21, 23 zur zugeordneten Kompensationskapazität 10, 18, 25 stets gleich ist. Im vorliegenden Fall beträgt dieses Kapazitätsverhältnis V ca. 10.

Die Ansteuerschaltung 27 steuert das Zu- und Abschalten der ersten und zweiten Kapazitäten 5, 8; 14, 16; 21, 23 sowie der Kompensationskapazitäten 10, 18, 25. Wenn beispielsweise das Paar von Kompensationskapazitäten 5, 8 mittels der Schalter 4, 7 durch Öffnen derselben abgeschaltet wird, wird die diesen Kapazitäten zugeordnete Kompensationskapazität 10 gleichzeitig durch Schließen des Schalters 9 zugeschaltet. Entsprechend ist das Paar von Kapazitäten 14, 16 mit der diesen zugeordneten Kompensationskapazität 18 gegengleich angesteuert, und schließlich ist entsprechend das Paar von Kapazitäten 21, 23 mit der diesem Kapazitätenpaar zugeordneten Kompensationskapazität 25 gegengleich angesteuert. Mittels der binär abgestuften, symmetrisch zueinander vorgesehenen frequenzbestimmenden Kapazitäten 5, 8; 14, 16; 21, 23 ist ein diskretes Verstellen der Schwingkreisfrequenz in sehr exakter Weise mit geringem Aufwand möglich. Mittels der jeweils zugeordneten Kompensationskapazitäten 10, 18, 25, welche jeweils entgegengesetzt geschaltet werden, bleibt unabhängig von der Wahl der frequenzbestimmenden Kapazitäten stets der Arbeitspunkt der Quarzoszillatorschaltung erhalten. Die Schaltung kann selbstverständlich auf beliebig viele weitere schaltbare Kapazitäten gemäß dem vorgestellten Prinzip erweitert werden.

Alternativ zur gezeigten binären Abstufung können die Kapazitäten auch beispielsweise alle gleich groß sein.

Zusätzlich zu der gezeigten Ausführung mit je drei parallelgeschalteten, unabhängig voneinander zu- und abschaltbaren Kapaziätszweigen können gemäß vorliegendem Prinzip auch beliebig viele weitere, schaltbare Zweige vorgesehen sein.

### Bezugszeichenliste

- 1: Schwingquarz
- 2: Widerstand
- 3: Entdämpfungsverstärker
- 4: Schalter
- 5: Kondensator
- 6: Bezugsknoten
- 7: Schalter
- 8: Kondensator
- 9: Schalter
- 10: Kapazität
- 11: Kapazität
- 12: Inverter
- 13: Schalter
- 14: Kondensator
- 15: Schalter
- 16: Kondensator
- 17: Schalter
- 18: Kapazität
- 19: Inverter
- 20: Schalter
- 21: Kondensator
- 22: Schalter
- 23: Kondensator
- 24: Schalter
- 25: Kapazität
- 26: Inverter
- 27: Ansteuerschaltung
- C: Kapazitätswert
- V: Kapazitätsverhältnis
- Y: Eingangsadmittanz

## Patentansprüche

1. Quarzoszillatorschaltung, aufweisend
- einen Schwingquarz (1) mit einem ersten und einem zweiten Anschluß,
- einen Entdämpfungsverstärker (3) mit einem Eingang und einem Ausgang, die mit je einem Anschluß des Schwingquarzes (1) gekoppelt sind,
- ein Mittel zur Arbeitspunkteinstellung (2), welches den Schwingquarz (1) mit dem Eingang des Entdämpfungsverstärkers (3) koppelt,
- ein erstes kapazitives Bauteil (5), welches den ersten Anschluß des Schwingquarzes (1) mit einem Bezugsknoten (6) verbindet,
- ein zweites kapazitives Bauteil (8), welches den zweiten Anschluß des Schwingquarzes (1) mit dem Bezugsknoten (6) verbindet,
- wobei zumindest eines der beiden kapazitiven Bauteile (5, 8) verstellbar ausgebildet ist und
- eine Kompensationskapazität (10), welche einerseits mit dem Eingang des Entdämpfungsverstärkers (3) und andererseits mit dem Bezugsknoten (6) verbunden ist und komplementär zu dem kapazitiven Bauteil (5, 8) verstellt wird.

2. Quarzoszillatorschaltung nach Anspruch 1,
**dadurch gekennzeichnet, daß**
mehrere erste (5, 14, 21) und mehrere zweite (8, 16, 23) kapazitive Bauteile vorgesehen sind, welche jeweils parallel miteinander verschaltet und paarweise unabhängig voneinander zu- und abschaltbar sind und
daß jedem ersten kapazitiven Bauteil (5, 14, 21) je eine Kompensationskapazität (10, 18, 25) geordnet ist.

3. Quarzoszillatorschaltung nach Anspruch 2,
**dadurch gekennzeichnet, daß**
die den ersten kapazitiven Bauteilen (5, 14, 21) zugeordneten Kompensationskapazitäten (10, 18, 25) zu den ersten kapazitiven Bauteilen (5, 14, 21) jeweils ein festes Kapazitätsverhältnis (V) haben.

4. Quarzoszillatorschaltung nach Anspruch 2 oder 3,
**dadurch gekennzeichnet, daß**
die Kompensationskapazitäten (10, 18, 25) unabhängig voneinander zu- und abschaltbar ausgebildet sind.

5. Quarzoszillatorschaltung nach einem der Ansprüche 2 bis 4,
**dadurch gekennzeichnet, daß**
die ersten und zweiten kapazitiven Bauteile (5, 8; 14, 16; 21, 23) sowie die Kompensationskapazitäten (10, 18, 25) mit je einem Schalter (4, 7; 13, 15; 20, 22; 9, 17, 24) zum ihrem Zu- und Abschalten gekoppelt sind, wobei die Schalter (4, 7; 13, 15; 20, 22; 9, 17, 24) je einen Steueranschluß haben, und daß eine Ansteuerschaltung (27) vorgesehen ist, welche den Steueranschlüssen der den ersten und zweiten kapazitiven Bauteilen (5, 8; 14, 16; 21, 23) zugeordneten Schaltern (4, 7; 13, 15; 20, 22) Steuersignale nicht-invertiert und den den Kompensationskapazitäten (10, 18, 25) zugeordneten Schaltern (9, 17, 24) invertiert zuführt.

6. Quarzoszillatorschaltung nach einem der Ansprüche 2 bis 5,
**dadurch gekennzeichnet, daß**
der Quotient aus dem Kapazitätswert des ersten kapazitiven Bauteils und der dem Kapazitätswert der zugeordneten Kompensationskapazität (V) größer als 5 beträgt.

7. Quarzoszillatorschaltung nach einem der Ansprüche 1 bis 6
**dadurch gekennzeichnet, daß**
eine Mindestkapazität (11) vorgesehen ist, welche den Eingang des Entdämpfungsverstärkers (3) fest mit dem Bezugsknoten (6) verbindet.

8. Quarzoszillatorschaltung nach einem der Ansprüche 1 bis 7,
**dadurch gekennzeichnet, daß**
der Entdämpfungsverstärker (3) als Inverter ausgebildet ist.

9. Quarzoszillatorschaltung nach Anspruch 8,
**dadurch gekennzeichnet, daß**
der Entdämpfungsverstärker (3) als CMOS-Inverter ausgebildet ist.

10. Quarzoszillatorschaltung nach einem der Ansprüche 1 bis 9,
**dadurch gekennzeichnet, daß**
das Mittel zur Arbeitspunkteinstellung (2) als Widerstand ausgebildet ist.

## Claims

1. A crystal oscillator circuit, having
- an oscillating quartz (1) with a first and a second connection,
- a deattenuation amplifier (3) with an input and an output, which are each coupled to one connection of the oscillating quartz (1),
- a means for operating point adjustment (2), which couples the oscillating quartz (1) to the input of the deattenuation amplifier (3),
- a first capacitive component (5), which connects the first connection of the oscillating quartz (1) to a reference node (6),
- a second capacitive component (8) which connects the second connection of the oscillating quartz (1) to the reference node (6),
- with at least one of the two capacitive components (5, 6) being designed to be adjustable, and
- a compensation capacitance (10) which is connected on the one hand to the input of the deattenuation amplifier (3) and on the other hand to the reference node (6) and is adjusted in a complementary manner to the capacitive component (5, 8).

2. The crystal oscillator circuit as claimed in claim 1,
**characterized in that**
a number of first capacitive components (5, 14, 21) and a number of second capacitive components (8, 16, 23) are provided, which are each connected in parallel with one another and can be connected and disconnected in pairs independently of one another, and
**in that** each first capacitive component (5, 14, 21) has a respective associated compensation capacitance (10, 18, 25).

3. The crystal oscillator circuit as claimed in claim 2,
**characterized in that**
the compensation capacitances (10, 18, 25) which are associated with the first capacitive components (5, 14, 21) each have a fixed capacitance ratio (V) to the first capacitive components (5, 14, 21).

4. The crystal oscillator circuit as claimed in claim 2 or 3,
**characterized in that**
the compensation capacitances (10, 18, 25) are designed such that they can be connected and disconnected independently of one another.

5. The crystal oscillator circuit as claimed in one of claims 2 to 4,
**characterized in that**
the first and second capacitive components (5, 8; 14, 16; 21, 23) as well as the compensation capacitances (10, 18, 25) are coupled to a respective switch (4, 7; 13, 15; 20, 22; 9, 17, 24) in order to connect and disconnect them, with the switches (4, 7; 13, 15; 20, 22; 9, 17, 24) each having a control connection, and **in that** a drive circuit (27) is provided, which supplies control signals in a non-inverted form to the control connections of the switches (4, 7; 13, 15; 20, 22) which are associated with the first and second capacitive components (5, 8; 14, 16; 21, 23), and supplies control signals in inverted form to the switches (9, 17, 24) which are associated with the compensation capacitances (10, 18, 25).

6. The crystal oscillator circuit as claimed in one of claims 2 to 5,
**characterized in that**
the quotient of the capacitance value of the first capacitive component and the quotient of the capacitance value of the associated compensation capacitance (V) is greater than 5.

7. The crystal oscillator circuit as claimed in one of claims 1 to 6,
**characterized in that**
a minimum capacitance (11) is provided, which permanently connects the input of the deattenuation amplifier (3) to the reference node (6).

8. The crystal oscillator circuit as claimed in one of claims 1 to 7,
**characterized in that**
the deattenuation amplifier (3) is in the form of an inverter.

9. The crystal oscillator circuit as claimed in claim 8,
**characterized in that**
the deattenuation amplifier (3) is in the form of a CMOS inverter.

10. The crystal oscillator circuit as claimed in one of claims 1 to 9,
**characterized in that**
the means for operating point adjustment (2) is in the form of a resistor.

## Revendications

1. Circuit d'oscillateur à quartz, comprenant
- un quartz (1) oscillant ayant une première et une deuxième borne,
- un amplificateur (3) de régénération ayant une entrée et une sortie qui sont couplées à respectivement une borne du quartz (1) oscillant,
- un moyen de réglage (2) du point de travail, qui couple le quartz (1 ) oscillant à l'entrée de l'amplificateur (3) de régénération,
- un premier composant (5) capacitif, qui relie la première borne du quartz (1) oscillant à un noeud (6) de référence,
- un deuxième composant (8) capacitif, qui relie la deuxième borne du quartz (1) oscillant au noeud (6) de référence,
- au moins l'un des deux composants (5, 8) capacitifs étant réglable et
- une capacité (10) de compensation qui est reliée, d'une part, à l'entrée de l'amplificateur (3) de régénération et, d'autre part, au noeud (6) de référence, et qui est réglée complémentairement aux composants (5, 8) capacitifs.

2. Circuit d'oscillateur à quartz suivant la revendication 1,
**caractérisé en ce qu'**il est prévu plusieurs premiers (5, 14, 21) et plusieurs deuxièmes (8, 16, 23) composants capacitifs, qui sont montés respectivement en parallèle et qui peuvent être connectés et déconnectés paire par paire indépendamment les uns des autres et
**en ce qu'**à chaque premier composant (5, 14, 21) capacitif est associée une capacité (10, 18, 25) de compensation.

3. Circuit d'oscillateur à quartz suivant la revendication 2,
**caractérisé en ce que** les capacités (10, 18, 25) de compensation associées aux premiers composants (5, 14, 21) capacitifs ont, par rapport aux premiers composants (5, 14, 21) capacitifs, respectivement, un rapport (V) fixe de capacité.

4. Circuit d'oscillateur à quartz suivant la revendication 2 ou 3,
**caractérisé en ce que** les capacités (10, 18, 25) de compensation sont constituées de manière à pouvoir être connectées et déconnectées indépendamment les unes des autres.

5. Circuit d'oscillateur à quartz suivant l'une des revendications 2 à 4,
**caractérisé en ce que** les premiers et deuxièmes composants (5, 8 ; 14, 16 ; 21, 23) capacitifs ainsi que les capacités (10, 18, 25) de compensation sont couplés à respectivement un interrupteur (4, 7 ; 13, 15 ; 20, 22 ; 9, 17, 24) pour leur connexion et leur déconnexion, les interrupteurs (4, 7 ; 13, 15 ; 20, 22 ; 9, 17, 24) ayant respectivement une borne de commande qui envoie, de façon non inversée, des signaux de commande aux bornes de commande des interrupteurs (4, 7 ; 13, 15 ; 20, 22) associés aux premiers et deuxièmes composants (5, 8 ; 14, 16 ; 21, 23) capacitifs et, de façon inversée, aux interrupteurs (9, 17, 24) associés aux capacités (10, 18, 25) de compensation.

6. Circuit d'oscillateur à quartz suivant l'une des revendications 2 à 5,
**caractérisé en ce que** le quotient de la valeur de la capacité du premier composant capacitif à la valeur de la capacité (V) de compensation associée est supérieure à 5.

7. Circuit d'oscillateur à quartz suivant l'une des revendications 1 à 6,
**caractérisé en ce qu'**il est prévu une capacité (11) minimum, qui relie fixement l'entrée de l'amplificateur (3) de régénération au noeud (6) de référence.

8. Circuit d'oscillateur à quartz suivant l'une des revendications 1 à 7,
**caractérisé en ce que** l'amplificateur (3) de régénération est constitué en inverseur.

9. Circuit d'oscillateur à quartz suivant la revendication 8,
**caractérisé en ce que** l'amplificateur (3) de régénération est constitué en inverseur CMOS.

10. Circuit d'oscillateur à quartz suivant l'une des revendications 1 à 9,
**caractérisé en ce que** le moyen de réglage (2) du point de travail est constitué sous la forme d'une résistance.
